(19) **Europäisches Patentamt European Patent Office Office européen des brevets**

(11) **EP 2 676 166 B1**

(12) **FASCICULE DE BREVET EUROPEEN**

(45) Date de publication et mention de la délivrance du brevet:
**02.01.2019 Bulletin 2019/01**

(21) Numéro de dépôt: **12706005.1**

(22) Date de dépôt: **14.02.2012**

(51) Int Cl.:
*G02F 1/01* [(2006.01)]

(86) Numéro de dépôt international:
**PCT/EP2012/052522**

(87) Numéro de publication internationale:
**WO 2012/110520 (23.08.2012 Gazette 2012/34)**

(54) **MODULATEUR TERAHERTZ**

**TERAHERTZMODULATOR**

**TERAHERTZ MODULATOR**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.02.2011 FR 1151189**

(43) Date de publication de la demande:
**25.12.2013 Bulletin 2013/52**

(73) Titulaire: **Centre National de la Recherche Scientifique (C.N.R.S.) 75794 Paris Cedex 16 (FR)**

(72) Inventeurs:
- **VASSANT, Simon 75010 Paris (FR)**
- **PARDO, Fabrice 94400 Vitry-sur-seine (FR)**
- **PELOUARD, Jean-Luc 75020 Paris (FR)**
- **GREFFET, Jean-Jacques 91370 Verrieres Le Buisson (FR)**
- **ARCHAMBAULT, Alexandre 75013 Paris (FR)**
- **MARQUIER, François 91160 Longjumeau (FR)**

(74) Mandataire: **Osha Liang 2, rue de la Paix 75002 Paris (FR)**

(56) Documents cités:
- **JANKE C ET AL: "All-optical switching of the transmission of electromagnetic radiation through subwavelength apertures", OPTICS LETTERS, vol. 30, no. 18, 15 septembre 2005 (2005-09-15), pages 2357-2359, XP002662624, OPT. SOC. AMERICA USA ISSN: 0146-9592 cité dans la demande**
- **XIN WU ET AL: "Thermally Tuning Terahertz Surface Plasmon Polaritons in Corrugated Semiconductor Films", JAPANESE JOURNAL OF APPLIED PHYSICS, vol. 48, no. 4, 1 avril 2009 (2009-04-01), pages 042302-1-042302-6, XP055010960, ISSN: 0021-4922, DOI: 10.1143/JJAP.48.042302**
- **LIBON I H ET AL: "An optically controllable terahertz filter", APPLIED PHYSICS LETTERS, vol. 76, no. 20, 15 mai 2000 (2000-05-15), pages 2821-2823, XP012025299, AIP, AMERICAN INSTITUTE OF PHYSICS, MELVILLE, NY, US ISSN: 0003-6951, DOI: 10.1063/1.126484**
- **VASSANT S ET AL: "Tailoring GaAs terahertz radiative properties with surface phonons polaritons", APPLIED PHYSICS LETTERS, vol. 97, no. 16, 161101, 18 octobre 2010 (2010-10-18), pages 161101-1-161101-3, XP012137316, AIP, AMERICAN INSTITUTE OF PHYSICS, MELVILLE, NY, US DOI: 10.1063/1.3497645**
- **KLEINE-OSTMANN T ET AL: "Room-temperature operation of an electrically driven terahertz modulator", APPLIED PHYSICS LETTERS, vol. 84, no. 18, 3 mai 2004 (2004-05-03), pages 3555-3557, XP012061307, AIP, AMERICAN INSTITUTE OF PHYSICS, MELVILLE, NY, US ISSN: 0003-6951, DOI: 10.1063/1.1723689**

- KERSTING R ET AL: "Terahertz phase modulator", ELECTRONICS LETTERS, vol. 36, no. 13, 22 juin 2000 (2000-06-22) , pages 1156-1158, XP006015394, IEE STEVENAGE, GB ISSN: 0013-5194, DOI: 10.1049/EL:20000837
- FEKETE L ET AL: "Active optical control of the terahertz reflectivity of high-resistivity semiconductors", OPTICS LETTERS, vol. 30, no. 15, 1 août 2005 (2005-08-01), pages 1992-1994, XP002662625, OPT. SOC. AMERICA USA ISSN: 0146-9592
- HENDRY E ET AL: "Optical control over surface-plasmon-polariton-assisted THz transmission through a slit aperture", PHYSICAL REVIEW LETTERS, vol. 100, no. 12, 123901, 28 mars 2008 (2008-03-28), pages 123901-1-123901-4, XP002662626, AMERICAN PHYSICAL SOCIETY USA ISSN: 0031-9007
- R G M Hillenbrand: "Acknowledgements", Nature, 11 July 2002 (2002-07-11), pages 159-163, XP55389033, Retrieved from the Internet: URL:http://www.nature.com [retrieved on 2017-07-07]

## Description

### Domaine technique de l'invention

La présente invention concerne les composants actifs dans le domaine de fréquence des térahertz. Plus précisément, l'invention se rapporte à un modulateur pour des radiations térahertz.

### Etat de l'art

Le domaine térahertz est généralement défini par les radiations dont la fréquence est comprise entre 0.1 et 30 THz. Cette bande de fréquence fait la jonction entre le domaine de l'électronique et le domaine de la photonique. Les dispositifs dans le domaine térahertz se heurtent à des limites de fonctionnement intrinsèques : les fréquences de travail sont trop élevées pour des composants basés sur l'électronique et les énergies sont trop faibles pour travailler efficacement avec des photons. Néanmoins, ce domaine de fréquences possède un fort potentiel applicatif, par exemple dans le domaine des télécommunications dans lequel les plages de fréquence habituellement attribuées aux télécoms arrivent à saturation. Notamment, l'attribution des plages de fréquences est d'ores et déjà saturée jusqu'à 0.3 THz au États-Unis. Ce potentiel d'applications active les travaux sur le développement de composants permettant de manipuler les radiations térahertz, et notamment les modulateurs.

Dans le domaine des modulateurs térahertz, on connaît un dispositif basé sur la transmission résonante au travers d'un réseau de trous sub-longueur d'onde structuré dans un cristal d'Antimoniure d'indium (InSb). Un tel dispositif est décrit par exemple dans Janke et al., « All-optical switching of the transmission electromagnetic radiation through subwavelength apertures » (Optics Lettres Vol.30, N°18, pages 2357-2359, 2005). Il est divulgué dans ce document comment la transmission résonante provenant du couplage entre une radiation térahertz et des plasmons polaritons de surface à la surface du cristal peut être contrôlée autour de 0.5 THz en excitant optiquement la structure. Néanmoins, comme le montrent les résultats publiés dans ce document, un tel contrôle est limité, y compris à basse température. De plus, on constate à température ambiante une transmission limitée à 0,2% au maximum de transmission.

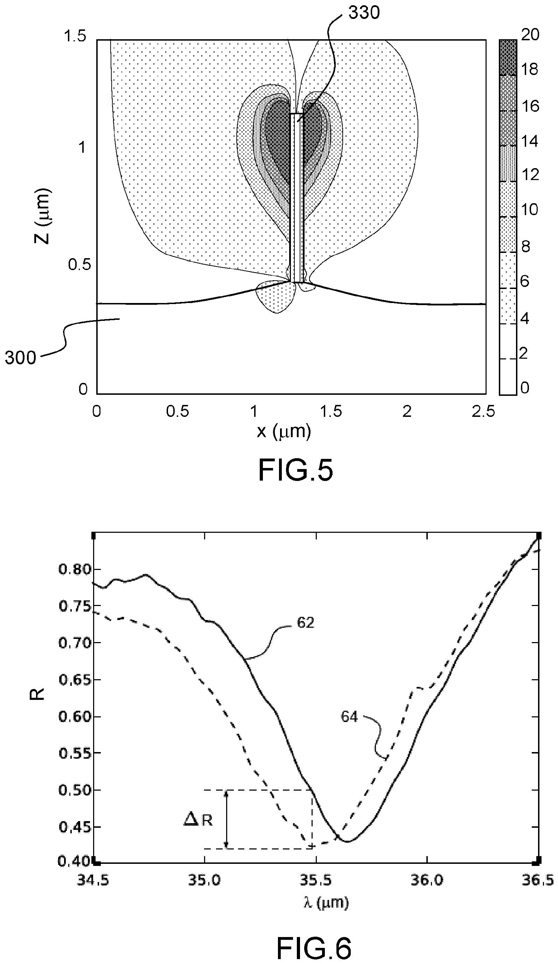

Un autre type de modulateur Terahertz est également décrit dans X.WU et al (« Thermally Tunning Surface Plasmon Polaritons in Corrugates Semiconductor Films », Japanese Journal of Applied Physics 48 (2009) 042302). Dans cet article, il est présenté théoriquement la possibilité de moduler les fréquences Térahertz en changeant la température d'un réseau en Antimoniure d'indium intercalé entre de l'air et un diélectrique. On peut constater (Figures 6a et 6b) que les simulations présentées dans cet article prévoient qu'à température ambiante la transmission est limitée à 0.3% maximum comme pour le dispositif divulgué dans l'article de Yanke et al.

Un objet de la présente invention consiste à présenter un modulateur térahertz pouvant notamment fonctionner de manière plus efficace à température ambiante.

### Résumé de l'invention

Selon un premier aspect, l'invention concerne un modulateur téraherz destiné à être utilisé dans une bande de fréquence d'utilisation donnée, comprenant :

- un cristal semi-conducteur polaire (10) présentant une bande de Reststrahlen recouvrant ladite bande de fréquence d'utilisation et présentant au moins une interface avec un milieu diélectrique;
- des moyens de couplage permettant le couplage résonant d'un phonon polariton d'interface (IPhP) supporté par ladite interface et d'une radiation incidente (2) de fréquence comprise dans ladite bande de fréquence d'utilisation; et
- des moyens de commande (20) aptes à modifier l'intensité du couplage entre ledit phonon polariton d'interface et ladite radiation incidente (2) par modification de la fonction diélectrique du cristal polaire (10) dans la bande de Reststrahlen du cristal polaire (10).

L'effet de résonance de la fonction diélectrique d'un cristal polaire dans la bande fréquentielle dite de Reststrahlen du cristal est ainsi utilisé pour créer un modulateur térahertz d'efficacité remarquable et fonctionnant à température ambiante. Le modulateur peut fonctionner en réflexion, la variation d'intensité du couplage entre le phonon polariton d'interface et la radiation incidente résultant en une variation de la réflectivité du composant à la longueur d'onde de l'onde incidente, ou en transmission, selon la mise en oeuvre du composant.

Avantageusement, le cristal polaire présente deux interfaces avec un milieu diélectrique, lesdites interfaces étant suffisamment rapprochées pour permettre le couplage de phonons polaritons d'interface se propageant sur chacune des interfaces. Le couplage de deux modes phonons polaritons d'interface permettra d'accentuer encore le confinement du champ électromagnétique et d'améliorer l'efficacité du modulateur, notamment en rendant plus sensible la variation du couplage par les moyens de commande.

Typiquement, la distance entre les deux interfaces pourra être inférieure à une centaine de nanomètres.

Selon un exemple, le cristal semi-conducteur polaire est un semi-conducteur III-V, par exemple de l'arséniure de gallium (GaAs), de l'arséniure d'aluminium (AlAs), du phosphure d'indium (InP), de l'arséniure d'indium (InAs), du phosphure de gallium (GaP), du nitrure de galium (GaN), etc. Selon un autre exemple, le cristal semi-conducteur polaire est un semi-conducteur II-VI, par exemple du Sélénium de Zinc (ZnSe), du tellurure de mercure (HgTe), du tellurure de Cadmium (CdTe), etc. ou un semi-conducteur I-VII, par exemple chlorure de sodium (NaCl), bromure de potassium (KBr), etc. Selon un autre exemple, le cristal semi-conducteur polaire est un semi-conducteur IV-IV comme le carbure de silicium (SiC). Par ailleurs, les alliages ternaires (à trois éléments, comme AlGaAs par exemple), les alliages quaternaires (à quatre éléments, par exemple InGaAlAs) ou plus, peuvent également être utilisés. Dans la suite de la description, le terme cristal semi-conducteur polaire regroupe l'ensemble de ces matériaux.

Selon une variante, le cristal polaire est dopé. La génération de porteurs libres dans le cristal polaire permet d'élargir et/ou de décaler la bande de résonance de la fonction diélectrique.

Selon un premier mode de réalisation du modulateur selon l'invention, les moyens de couplage sont formés intégralement dans le cristal polaire. Autrement dit, le cristal polaire est structuré pour former l'élément de couplage entre le phonon polariton d'interface et la radiation incidente.

Par exemple, le cristal polaire est structuré pour former une ou plusieurs lames de cristal formant chacune une antenne optique destinée au couplage avec la radiation incidente, les grandes faces de chacune desdites lames formant deux interfaces avec un milieu diélectrique, par exemple l'air ou le vide.

Avantageusement, les moyens de couplage comprennent une pluralité de ces lames. Selon un premier exemple, les lames sont toutes identiques, de forme et de dimensions optimisées pour le couplage avec une radiation incidente de fréquence comprise dans une bande spectrale fine d'utilisation. Selon un deuxième exemple, elles présentent des formes et des dimensions différentes, ce qui permet d'élargir la bande spectrale d'utilisation du modulateur.

Selon une première variante, la ou lesdites lames sont agencées perpendiculairement à un substrat, ledit substrat étant destiné à être agencé dans un plan perpendiculaire au plan d'incidence de la radiation incidente.

Selon une deuxième variante le ou lesdits éléments sont agencés dans un plan et forment une membrane suspendue, le plan de la membrane étant destiné à être agencé dans un plan perpendiculaire au plan d'incidence de la radiation incidente.

Dans le cas du premier exemple de réalisation ainsi décrit, les moyens de commande peuvent comprendre une source lumineuse destinée à éclairer ladite interface, de bande spectrale donnée de telle sorte que l'énergie des photons produits par ladite source lumineuse soit supérieure à l'énergie de gap dudit cristal polaire. L'éclairage par une simple source, par exemple une source émettant dans le visible pour des cristaux polaires comme le GaAs, permet ainsi la modification de la fonction diélectrique du cristal polaire et donc de l'intensité et/ou de la fréquence de couplage, ce qui résulte en une variation de la réflectivité du modulateur. Avantageusement, une longueur d'onde courte, c'est-à-dire présentant une énergie de photons très supérieure au gap, sera utilisée pour la source d'éclairage de commande. Une source d'éclairage large bande peut également être utilisée. Dans le cas où le cristal polaire se présente sous la forme d'une lame de cristal, un éclairage par la source lumineuse de commande peut être prévu sur chacune des interfaces formées par les grandes faces de la lame.

Lorsque les moyens de couplage comprennent une pluralité de lames, elles peuvent être agencés selon une seule direction. Alternativement, les lames peuvent être agencées selon deux directions perpendiculaires, permettant une insensibilité à la polarisation de la radiation térahertz incidente.

Selon un second mode de réalisation du modulateur selon l'invention, le cristal polaire forme au moins une couche mince entourée d'au moins une première et une deuxième couches barrières en matériau semi-conducteur diélectrique à fort énergie de gap de façon à former avec la couche en cristal polaire un ou plusieurs puits quantique(s).

Par exemple, les moyens de couplage pourront comprendre un ensemble de nanoantennes optiques et un miroir agencés de manière à former une cavité de résonance optique à l'intérieur de laquelle se trouve ledit puits quantique. Ainsi, un confinement de champ électromagnétique pourra notamment être obtenu dans le puits quantique.

Avantageusement, un espaceur pourra permettre d'adapter la largeur de ladite cavité de résonance optique.

Dans le second exemple de réalisation ainsi décrit, les moyens de commande peuvent être des moyens de commande électriques aptes à contrôler la densité électronique dans le(s) puits quantique(s).

Selon un deuxième aspect, l'invention concerne une méthode de modulation d'une radiation incidente de fréquence térahertz comprise une bande de fréquence d'utilisation donnée, incluse dans la bande de Reststrahlen d'un cristal polaire semi-conducteur, comprenant les étapes de :

- couplage résonant de la radiation de fréquence térahertz incidente et d'un phonon polariton d'interface à une interface du cristal polaire et d'un milieu diélectrique;
- variation de l'intensité du couplage par variation de la fonction diélectrique du cristal polaire dans la bande de Reststrahlen du cristal polaire.

La variation de l'intensité de couplage pourra résulter en une variation de la réflexion ou de la transmission de ladite radiation incidente sur ladite interface entre le cristal polaire et le milieu diélectrique.

Selon un premier mode de réalisation de la méthode, la variation de la fonction diélectrique du cristal polaire est obtenue en éclairant ladite interface entre le cristal polaire et le milieu diélectrique avec une source lumineuse visible, le cristal polaire étant structuré pour former au moins une antenne optique permettant le couplage avec la radiation incidente.

Selon un deuxième mode de réalisation de la méthode, dans lequel le cristal polaire forme au moins une couche mince entre au moins une première et une deuxième couches barrières en matériau semi-conducteur diélectrique à fort énergie de gap de façon à former un ou plusieurs puits quantique(s), la variation de la fonction diélectrique du cristal polaire est obtenue en appliquant une tension au cristal polaire pour contrôler la densité électronique dans le(s) puits quantique(s).

Selon un troisième aspect, l'invention concerne un système de transmission de données comprenant une source d'émission THz, un modulateur selon le premier aspect et un détecteur de radiation THz, le modulateur étant commandé en fonction d'un signal contenant lesdites données.

**Brève description des figures**

D'autres caractéristiques et avantages de l'invention apparaîtront à la lecture de la description qui suit, illustrée par les figures sur lesquelles :

La Figure 1 est un diagramme illustrant schématiquement une mise en oeuvre de l'invention.
Les Figures 2A et 2B sont des courbes montrant respectivement l'évolution de la partie réelle et de la partie imaginaire de la fonction diélectrique en fonction de la longueur d'onde pour du GaAs et du GaAs dopé.
La Figure 3 illustre un modulateur térahertz selon un premier mode de réalisation de l'invention.
La Figure 4A représente sous forme d'un schéma le couplage de phonons polaritons d'interface dans un modulateur térahertz selon le premier mode de réalisation de l'invention et la figure 4B illustre la courbe de réflectivité en fonction de la longueur d'onde, calculée dans un dispositif du type de la figure 4A.
La Figure 5 représente l'intensité du champ électrique calculé au voisinage d'une interface entre le cristal polaire et un diélectrique dans un modulateur térahertz selon le premier mode de réalisation de l'invention.
La Figure 6 illustre des courbes de réflectivité spectrale du modulateur selon le premier mode de réalisation de l'invention pour deux valeurs de commande du modulateur distinctes.
Les Figures 7A et 7B représentent sous forme d'un schéma une variante d'un modulateur selon le premier mode de réalisation de l'invention.
La Figure 8 montre un schéma d'un modulateur térahertz selon un deuxième mode de réalisation de l'invention.
La Figure 9 illustre des courbes de réflectivité spectrale du modulateur selon le deuxième mode de réalisation de l'invention pour trois valeurs de commande du modulateur distinctes.
La Figure 10 illustre le différentiel de réflectivité spectrale pour plusieurs angles d'incidence distincts de la radiation térahertz pour le modulateur selon le deuxième mode de réalisation de l'invention.

**Description détaillée**

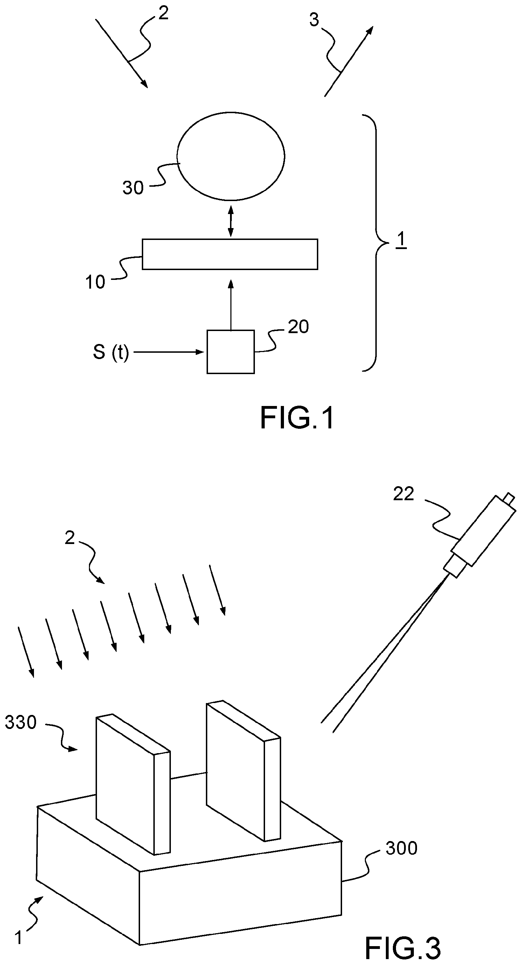

La Figure 1 est un diagramme qui représente de façon schématique un modulateur selon l'invention dans un exemple de mise en oeuvre. Dans cet exemple, une radiation térahertz incidente 2 de fréquence prédéterminée est réfléchie par un modulateur térahertz 1 selon l'invention pour donner une radiation térahertz réfléchie 3 dont l'intensité est modifiée par rapport à l'intensité de la radiation térahertz incidente 2 en fonction d'un signal de contrôle S(t), par exemple un signal portant un ensemble d'informations que l'on cherche à transmettre. Le modulateur 1 comprend généralement un cristal polaire 10, des moyens de commande 20 et des moyens de couplage 30. Le signal de contrôle S(t) est fourni aux moyens de commande 20 pour moduler l'intensité de la radiation réfléchie en fonction du temps. Comme cela sera décrit en détails par la suite, les moyens de commande 20 peuvent être optiques ou électriques. Le cristal polaire 10 comprend une interface avec un milieu diélectrique, (non représenté sur la figure 1), par exemple du vide, de l'air ou un matériau se comportant comme un diélectrique autour de la fréquence prédéterminée de la radiation térahertz incidente 2.

De manière générale, on appelle cristal polaire un cristal dont les atomes de la maille élémentaire possèdent des électronégativités différentes. Dans des cristaux polaires, le mouvement des atomes les uns par rapport aux autres influence la polarisabilité et donc la fonction diélectrique. Les cristaux polaires présentent une résonance de leur fonction diélectrique pour des énergies de photons proches de celles des phonons optiques, sur une bande de fréquence appelée bande de Reststrahlen. Dans cette bande de Reststrahlen, la partie réelle de la fonction diélectrique est négative. Le matériau se comporte alors optiquement comme un métal du fait de sa forte réflectivité et il supporte des phonons polaritons de surface, mélange entre un phonon optique et une onde électromagnétique, le tout se propageant à l'interface entre le cristal polaire et un milieu diélectrique. La résonance de la fonction diélectrique est très bien modélisée par un modèle de Lorentz, et la fonction diélectrique peut s'écrire, selon Born et al. (M. Born et K. Huang "dynamical theory of crystal lattices", Oxford University Press, New York, 1954):

$$\varepsilon(\omega) = \varepsilon_{\infty} \left( 1 + \frac{\omega_L^2 - \omega_T^2}{\omega_T^2 - \omega^2 - i\Gamma\omega} \right) \qquad (1)$$

Où $\omega_L$ et $\omega_T$ sont les fréquences des phonons optiques respectivement longitudinaux et transverses et $\Gamma$ un terme d'amortissement.

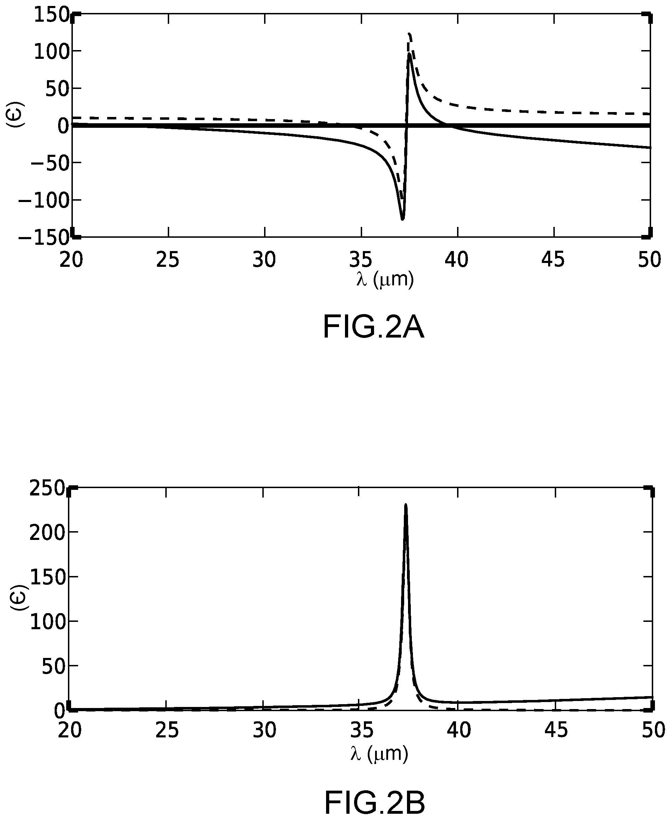

Les figures 2A et 2B représentent en fonction de la longueur d'onde respectivement la partie réelle et la partie imaginaire de la fonction diélectrique de l'arséniure de gallium (GaAs), typique des cristaux polaires, pour du GaAs pur (courbe en traits pointillés) et du GaAs dopé avec une densité de porteurs de 1,5 $10^{18}$ cm$^{-3}$ (courbe en trait plein). Par exemple pour une interface GaAs/air, la plage de longueur d'onde où l'onde de surface peut exister est donnée par la relation Re($\varepsilon$)<-1, où $\varepsilon$ est la fonction diélectrique de GaAs. Ceci correspond à la plage de longueurs d'onde suivante 35,57 $\mu$m < $\lambda$ < 37,30 $\mu$m. Pour le GaAs dopé, la plage de longueurs d'onde correspondant aux conditions d'existence de phonons polaritons de surface est élargie.

Tandis que la plupart des études publiées cherchent à éviter les plages de fréquence correspondant à la zone Reststrahlen dans laquelle la résonance engendre des variations extrêmement rapides de la fonction diélectrique et donc de la réflectivité, la déposante a montré au contraire qu'on pouvait mettre à profit cette zone de fréquences pour la conception de modulateurs extrêmement efficaces dans le domaine des térahertz, comme cela sera mis en évidence dans la suite de la description à travers des exemples de réalisation particuliers.

En particulier, les cristaux polaires potentiellement intéressants pour la génération de phonons polaritons de surface dans le domaine des fréquences térahertz sont les semi-conducteurs III-V, par exemple l'arséniure de gallium (GaAs), l'arséniure d'aluminium (AlAs), le phosphure d'indium (InP), l'arséniure d'indium (InAs) et le phosphure de gallium (GaP). Les semi-conducteurs II-VI sont également des cristaux polaires présentant des Reststrahlen dans la bande spectrale d'intérêt, par exemple ZnSe, HgTe, CdTe, de même que les éléments IV-IV comme SiC, les éléments I-VII ou des alliages composés de 3 (ternaire), 4 (quaternaire) ou plus éléments. D'une manière générale, la bande de Reststrahlen de ces matériaux est située dans l'infrarouge lointain, entre 10 et 50 microns, soit entre 6 et 30 térahertz.

Selon une variante, on pourra utiliser un cristal polaire dopé pour augmenter le nombre de porteurs. Le dopage du cristal polaire 10 permet d'accroître et décaler la bande de Reststrahlen du cristal pour laquelle la partie réelle de la fonction diélectrique est négative (voir figure 2A). Ainsi, la plage de longueur d'onde sur laquelle on peut travailler avec des modes d'interface est accrue. Ainsi, le dopage pourra être optimisé pour obtenir une meilleure modulation. La valeur optimum dépend de la géométrie du cristal polaire, ainsi que de sa nature. Par exemple pour GaAs, la déposante a obtenu comme cela sera décrit par la suite de meilleurs résultats de modulation avec un dopage de l'ordre de 1x$10^{18}$ cm$^{-3}$.

Les phonons polaritons d'interface étant des modes évanescents, il n'est cependant pas possible de les coupler avec un champ propagatif incident en éclairant simplement une surface plane. Les moyens de couplage 30 permettent d'assurer le couplage de la radiation térahertz incidente 2 et du champ évanescent du phonon polariton d'interface porté par l'interface entre le cristal polaire et le milieu diélectrique. Par exemple, dans un mode de réalisation où la radiation térahertz incidente 2 est une onde plane en espace libre, les moyens de couplage peuvent comprendre un prisme en configuration d'Otto, un prisme en configuration de Kretschman, un réseau de couplage, une antenne optique unique, ou une série de telles antennes. Les moyens de couplage peuvent par exemple être obtenus par une structuration du cristal polaire lui-même (antenne optique, réseau) ou par une structuration sous forme d'un empilement de couches minces pour générer une cavité résonante, comme cela sera décrit ultérieurement. Le couplage se traduit alors par une absorption résonante et peut être mis en évidence en analysant la réflectivité spectrale du modulateur 1. On peut définir une bande de fréquence d'utilisation du modulateur $\Delta\nu$, qui est la bande de fréquence de couplage incluse dans la bande de Reststrahlen du cristal et pour laquelle les moyens de couplages 30 permettent le couplage résonant de la radiation térahertz et d'un phonon polariton d'interface. Dans un mode de réalisation alternatif, la radiation THz incidente 2 peut être une onde guidée, ou une onde de surface. Les moyens de couplage du modulateur 1 au guide pourront alors comprendre un adaptateur d'impédance (« taper ») permettant une transmission optimale du guide au modulateur.

Les moyens de commande 20 tels que schématisés sur la figure 1 permettent de faire varier le couplage en modifiant la fonction diélectrique du cristal polaire 10 sur la bande de Reststrahlen. En particulier, les moyens de commande 20 permettent de modifier la fonction diélectrique du cristal polaire à la fréquence de la radiation térahertz incidente 2. La modification du couplage entraîne une variation de la réflectivité du modulateur 1 et donc une variation de l'intensité de la radiation térahertz réfléchie 3. En effet, la radiation térahertz incidente 2 peut être intégralement couplée à un phonon polariton d'interface de sorte que la totalité de l'énergie incidente soit transférée à l'onde d'interface.

L'onde d'interface se propage alors et l'énergie est dissipée dans le cristal polaire 10. La réflectivité pour ce type de couplage est donc nulle. En diminuant l'efficacité du couplage à une longueur d'onde donnée, seulement une partie de l'énergie incidente est cédée au phonon polariton d'interface et l'excédent d'énergie est alors réfléchi. Autrement dit, la commande pouvant changer non seulement l'intensité mais aussi la fréquence de couplage, si l'on regarde à une longueur d'onde donnée, la réflectivité est modulée. Les phonons polaritons d'interface excités par la radiation térahertz incidente 2 étant fortement confinés au voisinage de l'interface du cristal polaire 10, l'excitation par les moyens de commande 20 pour modifier les propriétés optiques du cristal polaire 10 peut être spatialement limitée à une zone d'excitation de faible volume où le champ du phonon polariton d'interface est confiné.

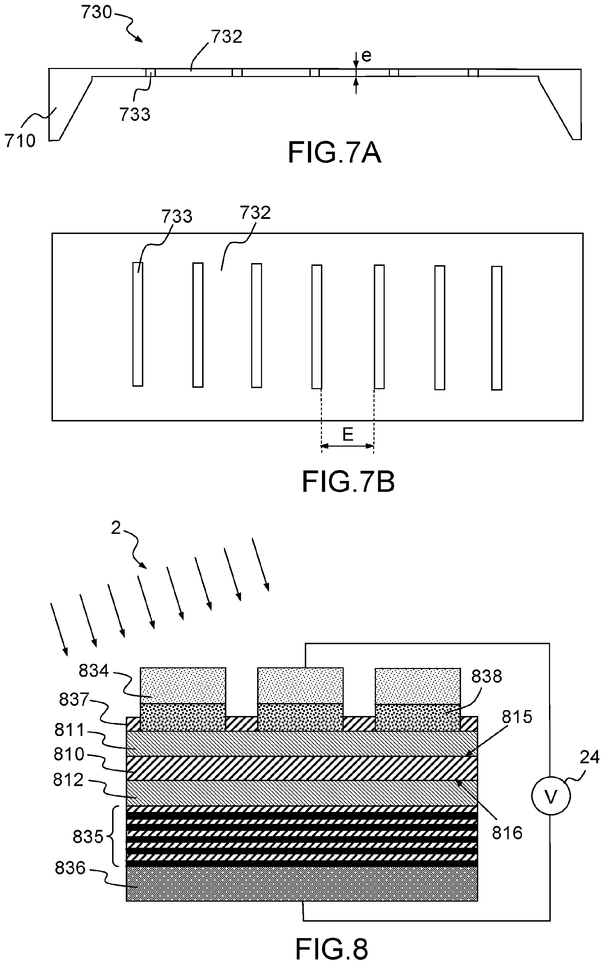

Dans la suite de la description, deux modes de réalisation principaux sont décrits pour la mise en oeuvre d'un modulateur THz selon l'invention. Le premier mode de réalisation, décrit au moyen des figures 3 à 6, met en oeuvre des moyens de commande optiques, tandis que le second mode de réalisation, décrit au moyen des figures 7 à 10, met en oeuvre des moyens de commande électriques.

Des exemples de réalisation d'un modulateur THz selon le premier mode de réalisation (moyens de commandes optiques) sont tout d'abord décrits.

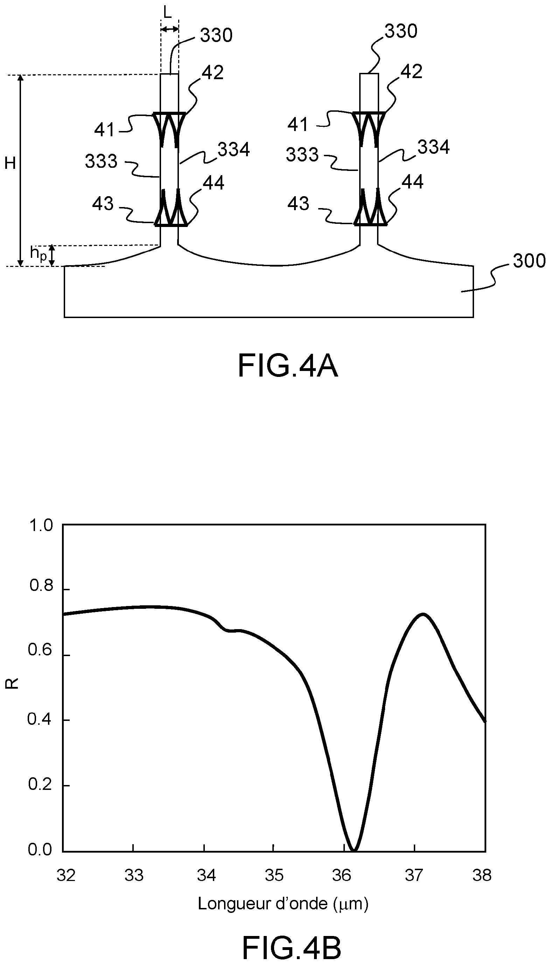

Les Figures 3 et 4A illustrent un premier exemple d'un modulateur THz selon le premier mode de réalisation. Dans cet exemple, le cristal polaire est structuré pour former au moins une lame de cristal 330, chaque lame formant une antenne optique permettant le couplage avec la radiation incidente. Par antenne optique, on entend généralement un élément capable de transférer l'énergie d'une radiation incidente vers un volume plus confiné. Les nanoantennes optiques sont largement étudiées et l'article de L.Novotny et al. (« Antennas for light », nature photonics, Vol 5, February 2011) en fait une très bonne description. Ici, la lame de cristal polaire est dimensionnée de telle sorte à former un résonateur dont les dimensions sont ajustées en fonction des propriétés fréquentielles recherchées pour le couplage. Le résonateur crée un champ évanescent qui va permettre le couplage avec la radiation incidente permettant de confiner l'énergie de l'onde incidente.

Dans l'exemple décrit sur les figures 3 et 4A, chaque lame de cristal 330 présente la forme d'un mur dont les grandes faces ont une forme sensiblement carrée ou rectangulaire et qui s'élève perpendiculairement à la surface d'un substrat 310, qui peut être lui-même fabriqué dans le même cristal. Le mur 330 comprend des parois parallèles 333, 334 formant chacune une interface entre le cristal polaire et le milieu diélectrique avoisinant, dans cet exemple le vide ou l'air. Alternativement, la lame de cristal peut être entourée par un matériau diélectrique, par exemple un matériau diélectrique organique de type résine. Les interfaces 333, 334 supportent des phonons polaritons d'interface 41-44. Avantageusement, la largeur L des lames 330 est suffisamment faible pour permettre un couplage entre des phonons polaritons d'interface 41-43 se propageant à l'interface 333 et des phonons polaritons d'interfaces 42-44 se propageant à l'interface 334 des deux cotés de la lame 330. Ceci permet d'augmenter le confinement du champ électromagnétique par augmentation de l'indice effectif du mode. Typiquement, la déposante a montré qu'une largeur des lames inférieure à quelques centaines de nanomètres permet de réaliser un tel couplage. Inversement, il faudra conserver une largeur de la lame suffisamment grande pour conserver un nombre de porteurs minimal.

Comme précédemment expliqué, la lame forme un résonateur dont la forme et les dimensions vont déterminer la bande fréquentielle de couplage qui sera aussi la bande d'utilisation du modulateur. Lorsque la lame est de forme sensiblement rectangulaire, seuls des modes verticaux existeront et l'on cherchera à optimiser la hauteur H de la lame en fonction de la longueur d'onde de couplage recherchée. D'une manière générale, la hauteur H des antennes optiques sera choisie de l'ordre de $\lambda_r/4n_{eff}$ où $\lambda_r$ est la fréquence de résonance et $n_{eff}$ l'indice effectif du mode. L'indice effectif dépend fortement de la nature du cristal polaire, et de son niveau de dopage. Par exemple, pour un cristal polaire en GaAs, la longueur d'onde de résonance est proche de 35.5 microns. L'épaisseur de la lame optique pourra être choisie entre 60 et 80 nm, la hauteur des antennes de l'ordre de 800 nm, l'indice effectif étant compris entre 7.5 et 10 pour un dopage de $1.5 \, 10^{18}$ cm$^{-3}$. Dans le cas d'une lame de forme carrée, le résonateur pourra présenter à la fois des modes horizontaux et verticaux et les paramètres d'optimisation du résonateur se trouveront modifiés. Une optimisation fine du résonateur peut être effectuée numériquement à l'aide de codes de type « Rigourous Coupled Wave Analysis » (RCWA), décrit notamment dans L. Li, Journal of Optical Society of America A, 14(10), 2758 (1997), ou «Rigourous Maxwell with Constitutive B-spline approximation» (RMCB) décrite dans P . Bouchon, Journal of Optical Society of America A, 27(4), 696 (2010). Des codes commerciaux (Reticolo) peuvent aussi être utilisés.

Dans l'exemple de la figure 4A, le pied de gravure au pied du mur 330 visible sur la figure 4A est une conséquence d'une gravure mal maîtrisée et pourra être modélisé par une forme parabolique sur une hauteur $h_g$ pour laquelle le pied du mur a une forme évasée, afin d'être pris en compte dans l'optimisation de la structure.

A titre d'exemple, la figure 4B illustre la réflectivité R d'un réseau selon la réalisation représentée sur la figure 4A, avec un cristal polaire en GaAs. Pour le calcul de la réflectivité, les paramètres suivants ont été considérés : période des murs 330 égale à 2.5 $\mu$m, hauteur des murs égale à 2,8 $\mu$m, hauteur $h_p$ égale à 600 nm, largeur des murs égale à 65 nm. Sur cette figure, on observe que la réflectivité tombe à zéro à une longueur d'onde proche de 36 $\mu$m (correspondant à une fréquence de 8,3 Térahertz incluse dans la bande de Restrahlen du GaAs), du fait du couplage résonant entre l'onde incidente térahertz et les IPhP.

Les moyens de commande optiques 22 éclairent la ou les lames de cristal polaire 330 avec une radiation lumineuse dont l'énergie des photons est supérieure à l'énergie de gap du cristal polaire de manière à créer des porteurs libres. La création de porteurs libres entraîne une modification de la fonction diélectrique du cristal polaire qui se traduit par un décalage de la résonance du phonon polariton d'interface. Par exemple, pour un cristal polaire formé de GaAs dont l'énergie de gap à température ambiante est $E_g$=1.42 eV, une source lumineuse de longueur d'onde visible, par exemple de type diode laser produira des photons d'énergie suffisante pour produire des porteurs libres. Pour une longueur d'onde d'émission autour de 630 nm par exemple, l'énergie des photons est environ égale à 1.96 eV. Dans le cas d'un autre cristal polaire, par exemple GaN, l'énergie de gap étant de 3.44eV, la source lumineuse devra émettre des longueurs d'ondes inférieures à 360 nm. De manière générale, tout rayonnement d'énergie supérieure à l'énergie de gap du cristal polaire pourra être utilisé. Avantageusement, on choisira une longueur d'onde courte (énergie des photons très supérieure au gap) pour renforcer l'absorption près de la surface. Du fait du très fort confinement du champ électrique, il est possible de commander le modulateur THz ainsi réalisé avec une source visible de faible puissance. La source d'éclairage pourra être choisie large bande. Selon une variante, un éclairage des deux côtés de la lame 330 formant l'antenne de couplage pourra être réalisé.

Le choix d'un ensemble d'antennes optiques formées par exemple par des lames de cristal optique du type de celles décrites précédemment pourra permettre par exemple de couvrir toute la surface du composant éclairée par la source d'éclairage de commande 22. On pourra alors choisir des lames de forme et de dimensions identiques pour optimiser le couplage dans une bande de fréquences d'utilisation fine, ou au contraire, varier la forme et/ou les dimensions des lames pour élargir la bande de fréquences d'utilisation. Par exemple, on pourra dans le cas de lames de cristal, choisir des lames dont les grandes faces sont carrées ou rectangulaires et avec des dimensions différentes. Par ailleurs, il est possible de prévoir un agencement périodique de ces antennes, par exemple pour faciliter la fabrication du composant ; cependant, la périodicité ainsi que la densité dans la répartition des antennes n'ont que peu d'effet sur le couplage, le couplage étant obtenu par le seul effet du rayonnement du champ évanescent par l'antenne. Cependant, on cherchera à ne pas espacer trop les antennes les unes des autres, afin de ne pas exciter d'ordres diffractés. Typiquement, les antennes seront distantes d'une valeur inférieure à la longueur d'onde. Enfin, on pourra choisir de disposer les antennes selon une direction principale. Alternativement, on pourra choisir de les disposer selon deux directions sensiblement perpendiculaires, de façon à supprimer la sensibilité du composant à la polarisation de la radiation térahertz incidente.

La figure 5 met en évidence le confinement du champ électrique dans une structure du type de celle des figures 3 et 4. L'intensité du champ électrique selon la direction perpendiculaire aux interfaces 333 et 334, et normalisée par l'intensité du champ électrique incident est calculée (par exemple au moyen d'un logiciel du type RCWA, RMCB ou Reticolo) pour un agencement périodique d'antennes résonantes. La figure 5 représente uniquement une période (2.5 microns) de la structure périodique. L'antenne représentée est en GaAs dopé à 1.5 $10^{18}$ cm$^{-3}$, elle mesure 800 nm de haut, 80 nm de large. L'indice effectif élevé du mode couplé entre les deux interfaces 333, 334 permet de confiner le champ électromagnétique dans un volume très faible. Ceci permet de limiter le volume dans lequel la concentration d'électrons doit être modifiée pour modifier l'intensité du couplage et facilite ainsi l'excitation optique du cristal polaire 10. La déposante a ainsi montré qu'à la résonance, pour un cristal polaire en GaAs dopé, le volume du mode couplé est de l'ordre de $\lambda^3/10^6$ où $\lambda$ est la longueur d'onde de la radiation THz incidente.

La figure 6 représente des mesures de réflectivité spectrale effectuées par la déposante sur un modulateur THz réalisé selon le premier mode de réalisation de l'invention. Plus précisément, le modulateur dont la réflectivité est représentée sur la Figure 6 comprend un cristal de GaAs dopé à la surface duquel est formé un réseau de murs dont la largeur, la hauteur et la période sont respectivement de 65 nm, 800 nm et 2.5 $\mu$m avec une hauteur du pied de gravure de 120 nm. Le cristal est éclairé par un laser HeNe à la longueur d'onde de 633 nm avec un angle d'incidence de 15°. La figure 6 comprend une première courbe 62 qui représente la réflectivité spectrale du modulateur 1 dans une situation où les moyens de commande optiques 22 ne sont pas activés et une deuxième courbe 64 qui représente la réflectivité spectrale du modulateur dans une situation où les moyens de commande optiques 22 sont activés avec une puissance d'éclairement de 4 mW/cm$^2$. La Figure 6 montre clairement un décalage de la fréquence de résonance du phonon polariton d'interface vers les longueurs d'onde plus courtes sous éclairement à 633nm. Quantitativement, le décalage mesuré est de 230 nm. A la fréquence de résonance $\lambda_R$, le couplage est maximal et correspond à une absorption résonante à laquelle la réflectivité est minimale. La variation relative de réflectivité est défini par:

$$\frac{\Delta R}{R} = \frac{R_- - R_+}{R_-} \qquad (2)$$

où $R_-$ est la réflectivité minimum, et $R_+$ la réflectivité maximum du modulateur 1. Pour cet exemple, la variation maximum est obtenue en considérant $R_-$ comme étant la réflectivité du modulateur 1 lorsque les moyens de commande optiques 22 sont activés et R+ est la réflectivité du modulateur 1 lorsque lesdits moyens sont désactivés. La variation relative atteint 40%. La déposante a montré que l'optimisation théorique du couplage en modifiant la géométrie des murs, en particulier la hauteur de ces derniers en fonction de leur largeur, permet une absorption quasi totale du rayonnement et d'atteindre une variation relative de réflectivité de plus de 4000%. Pour un cristal de GaAs non dopé la déposante a calculé que la largeur et la hauteur d'une antenne de couplage optimisée de type de celle représentée sur les figures 3 et 4, sont compris entre respectivement 60 et 70 nm pour la largeur, avec une hauteur supérieure ou égale à 2,8 microns. De manière générale, comme on l'a expliqué précédemment, on vérifie que la périodicité des murs est peu importante. Par ailleurs, à une épaisseur de mur donnée correspond une hauteur optimum à laquelle le rayonnement incident est totalement absorbé.

Un modulateur selon le premier mode de réalisation tel que décrit sur les Figures 3 et 4A peut être fabriqué selon les procédés classiques de la microélectronique. Par exemple, la fabrication d'un modulateur du type de celui de la figure 3 comprend les étapes de fabrication suivantes : déshydratation et dépôt d'une couche mince de résine sur le cristal de GaAs ; lithographie électronique négative de la résine ; dépôt d'un masque en titane/nickel par lift-off pour servir de protection pour une gravure sèche ; retrait chimique du masque. Une variante permettant d'éviter la formation d'un pied de gravure peut mettre en jeu une couche d'arrêt. A partir d'un substrat, on dépose par épitaxie une couche d'arrêt, par exemple 100 nm d'$Al_{80}Ga_{20}As$, par dessus laquelle on dépose une couche de cristal polaire, par exemple GaAs, dont l'épaisseur sera égale à la hauteur visée pour les antennes. Ensuite, on procède à une gravure du cristal polaire, gravure sélective qui s'arrêtera sur la couche d'arrêt.

Les Figures 7A et 7B représentent une vue en coupe (Figure 7A) et une vue de dessus (Figure 7B) d'une variante de modulateur selon le premier mode de réalisation précédemment décrit. Dans cette variante, le cristal polaire est structuré pour former un ensemble lames de cristal polaire 732 séparées par des fentes 733 et qui forment une membrane 730 structurée, suspendue au-dessus d'un substrat 710. La géométrie des lames de cristal polaire 732 comprises entre deux fentes correspond à la géométrie des lames de cristal ou « murs » 330 du mode de réalisation précédemment décrit. Comme dans l'exemple des figures 3 et 4, les lames de cristal 732 forment des antennes de couplage pour coupler la radiation incidente avec les phonons polaritons d'interfaces supportés aux interfaces des lames de cristal avec le milieu diélectrique environnant. L'épaisseur e de la membrane correspond à la largeur L des murs 330 et l'espacement E entre les fentes 733 correspond à la hauteur H des murs 330.

L'optimisation de la structure pourra se faire de la même manière que décrite précédemment. Notamment, dans le cas d'un arrangement d'une pluralité de lames optiques, on pourra les choisir de la même forme (par exemple carrée ou rectangulaire) et de mêmes dimensions, ou au contraire varier les formes et/ou les dimensions pour élargir la bande de fréquence d'utilisation du modulateur. De même, on pourra agencer les lames selon une direction principale, comme cela est représenté sur la figure 7B, ou au contraire, agencer les lames selon deux directions perpendiculaires, de façon à rendre le composant insensible à la polarisation.

Un modulateur tel que décrit sur les Figures 7A et 7B est par exemple fabriqué selon les étapes de fabrication suivantes. Sur un substrat 710 (par exemple GaAs), on dépose, par exemple par épitaxie, une couche d'arrêt (par exemple $Al_{80}Ga_{20}As$), puis une nouvelle couche de GaAs. A l'aide de techniques classiques de lithographie et de gravure, on définit les motifs dans la couche supérieure de GaAs, motifs débouchant sur la couche d'arrêt. Ensuite, par attaque chimique, le substrat est gravé jusqu'à la couche d'arrêt. Cette dernière est ensuite retirée de manière sélective, et il ne reste que les motifs gravés précédemment sous la forme d'une membrane structurée.

Comme dans l'exemple de la figure 3, la membrane ainsi formée pourra être éclairée par une source d'éclairage de commande (non représentée sur la figure 7A). La membrane pourra fonctionner en réflexion ou en transmission. Dans ce dernier cas, une transmission supérieure correspondra à une meilleure intensité de couplage tandis qu'une transmission inférieure correspondra à une moins bonne intensité de couplage. Un éclairage des deux côtés de la membrane peut également être envisagé pour améliorer l'efficacité de la modulation.

Un exemple de réalisation d'un modulateur THz selon le second mode de réalisation (moyens de commandes électriques) est ensuite décrit au moyen des figures 8 à 10.

Dans ce mode de réalisation, le cristal polaire 10 forme une couche mince dans un empilement successif de couches minces en matériaux semi-conducteur, les moyens de commande sont formés par des moyens de commande électriques 24 et les moyens de couplage sont formés par un ensemble d'antennes optiques 834 associé à un miroir 836 de manière à former une cavité optique à l'intérieur de laquelle est agencé l'empilement des couches minces en matériau semi-conducteur. Avantageusement, un espaceur 835 permet d'ajuster la largeur de la cavité.

Plus précisément, l'empilement de couches minces comprend successivement une première couche barrière 811, la couche mince de cristal polaire 810 et une deuxième couche barrière 812. Les couches barrières 811 et 812 présentent chacune une interface 815, 816 avec la couche de cristal polaire 810 et sont formées en matériaux semi-conducteurs diélectriques à forte énergie de gap par rapport au cristal polaire 810 de manière à ce que l'empilement de la première couche barrière 811, de la couche mince de cristal polaire 810 et de la deuxième couche barrière 812 forment un puits quantique dont les propriétés sont utilisées pour la commande électrique du modulateur, comme cela sera expliqué par la suite. Les matériaux à grand gap formant les couches 811 et 812 sont choisis en fonction du cristal polaire 810 utilisé. Par exemple, le cristal polaire 810 peut être formé de GaAs et les couches barrières 811 et 812 peuvent par exemple être formées d'un alliage AlGaAs à 33% d'aluminium ($Al_{33}Ga_{67}As$).

Les épaisseurs des couches 810, 811 et 812 sont dictées par la conception électronique de la structure. En particulier, l'épaisseur de la couche 810 est choisie de manière à ce que l'énergie de transition entre les niveaux d'énergie du puits quantique formé par les couches 811-810-812 soit voisine de l'énergie du mode d'interface supporté par le cristal polaire 810. Par exemple, pour un puits quantique en GaAs et des barrières en $Al_{33}Ga_{67}As$, l'énergie visée est 36meV, ce qui donne une épaisseur de GaAs de 21 à 22 nm.

La population du puits quantique est assurée par un apport de porteurs. Cet apport peut être effectué de manière différente, connus de la physique des transistors à effet de champ (HEMT). Par exemple, dans la structure de la figure 8, un plan de dopage (densité $8x10^{12}$ $cm^{-2}$) est ajouté dans la couche barrière 811. Alternativement, le puits peut être directement dopé, ou un dopage volumique de la couche barrière peut être effectué.

D'autres variantes sur la géométrie des puits peuvent par ailleurs être envisagées. Par exemple, selon une variante, un système formé de plusieurs puits quantiques pourra être utilisé.

Les moyens de couplage sont formés dans cet exemple par un ensemble d'antennes optiques 834, avantageusement métalliques, associé à un miroir 836 de manière à former une cavité optique. L'épaisseur de la cavité, qui peut être ajustée par l'espaceur 835, ainsi que le dimensionnement des antennes optiques 834 sont déterminés pour exciter un mode de phonon polariton d'interface aux interfaces 815 et 816 entre le cristal polaire 810 et les couches barrières 811 et 812. La cavité optique permet, en ajustant la taille de l'espaceur 835, de concentrer le champ électromagnétique dans le puits quantique. Le miroir 836 est par exemple un substrat en GaAs dopé, le dopage permettant de rendre le GaAs réfléchissant aux longueurs d'onde considérées, ou en métal, par exemple en or. La formation de cette cavité permet d'obtenir un facteur 5 d'exaltation sur l'intensité du champ dans la cavité.

Par ailleurs, la déposante a montré que l'on pouvait tirer profit du fait que la fonction diélectrique du cristal polaire 10 est proche de zéro à la longueur d'onde du mode d'interface lié au puits quantique. Ceci permet d'avoir un champ très confiné dans le cristal polaire. Par exemple, dans le cas d'un puits quantique en GaAs et de barrières en $Al_{33}Ga_{67}As$, le facteur d'exaltation de l'intensité du champ est de 140.

La structure réalisée bénéficie ainsi de deux effets (cavité et fonction diélectrique proche de 0) pour donner au final un facteur d'exaltation de l'intensité du champ de 700 environ tout en confinant le champ électromagnétique dans le puits quantique.

Avantageusement, une couche de protection 837, par exemple en GaAs est déposée sur la couche barrière 811 pour prévenir l'oxydation de cette couche. Les antennes de couplage 834 peuvent être agencées sous la forme d'un ensemble unidimensionnel d'antennes optiques métalliques. Alternativement, un ensemble présentant un motif à deux dimensions peut être agencé pour permettre une structure insensible à la polarisation de la radiation THz incidente. Par exemple, les antennes optiques de couplage 834 sont formées en or (Au). Avantageusement, une couche d'accroché 838 est interposée entre la couche supérieure de l'empilement et l'ensemble des antennes optiques 834 pour favoriser l'adhérence des antennes optiques au modulateur. Par exemple, la couche d'accroché 838 peut être formée en titane (Ti). L'espaceur peut être fabriqué par épitaxie sur le substrat de GaAs dopé. L'espaceur 835 peut par exemple être formé d'un alliage AlGaAs à 50% d'aluminium. Avantageusement, l'espaceur 835 peut être formé d'une alternance de fines couches (super-réseau) de GaAs et d'AlAs. Avantageusement, tout l'empilement peut être fabriquée par épitaxie. Dans le cas d'une technologie reportée, cette couche peut aussi être formée par un autre matériau ($Si_3N_4$, $SiO_2$ par exemple).

Un modulateur selon le deuxième mode de réalisation tels que décrit sur la Figure 8 est par exemple fabriqué selon les étapes de fabrication suivantes. Sur un substrat de GaAs dopé 836, les couches 835, 812, 810, 811 et 837 sont déposées par épitaxie. Ensuite, une lithographie UV est réalisée dans une résine photosensible pour définir la géométrie des antennes optiques. La couche 837 est gravée chimiquement, et les couches constituant les antennes optiques (couches d'accroché 838 et métallique 834) sont déposées par évaporation.

Les moyens de commande électriques 24 peuvent consister en une source de tension connectée au réseau d'antennes optiques 834 (connectées électriquement entre elles) et au miroir 836. Les moyens de commande électriques 24 permettent de contrôler la densité électronique dans le puits quantique. L'application d'une tension négative a pour effet de relever la bande de conduction par rapport au niveau de Fermi du puits quantique, entraînant une chute de la densité des porteurs. L'effet inverse est obtenu en appliquant une tension positive. On abaisse la bande de conduction, ce qui rapproche le fond du puits du niveau de Fermi, et donc augmente la densité de porteurs dans le puits. La commande électrique, en changeant la densité électronique va changer la fonction diélectrique du puits, qui ne sera alors plus aussi proche de zéro à la longueur d'onde du mode d'interface. De ce fait, l'excitation du mode sera moins efficace. La déposante a montré que la modification du couplage peut être due au plasma d'électron et/ou aux transitions intersous-bandes dans le puits.

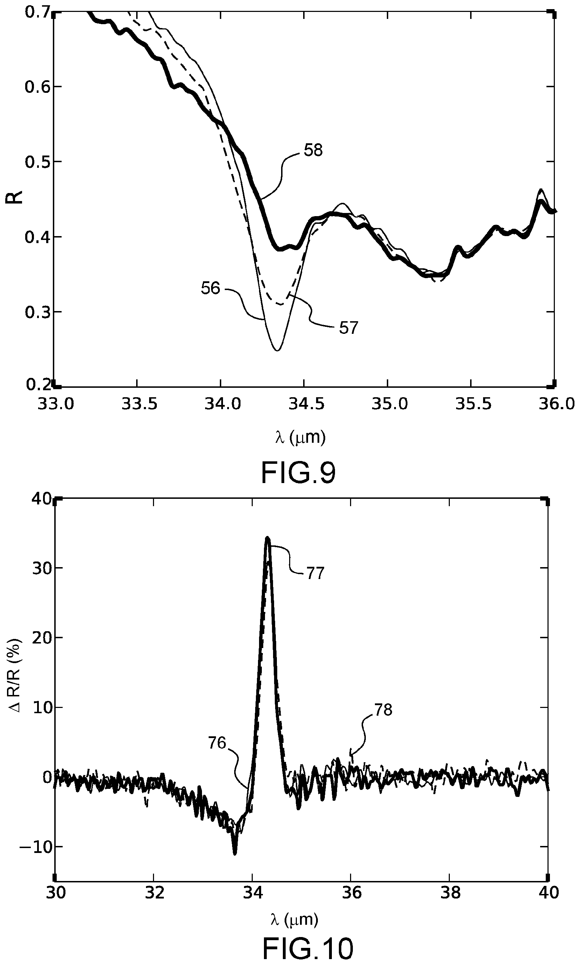

La Figure 9 présente des mesures de réflectivité spectrale effectuées par la déposante sur un exemple de modulateur THz réalisé selon le deuxième mode de réalisation de l'invention et tel que décrit sur la figure 8. Les mesures sont effectuées avec un spectromètre à transformée de Fourier. Plus précisément, le modulateur dont la réflectivité est représentée sur la Figure 9 comprend une couche miroir 836 de GaAs dopé à $N_e$=$1.5.10^{18}$ $cm^{-3}$, un espaceur 835 formé d'une alternance de mono-couches de GaAs et d'AlAs d'une épaisseur totale de 700 nm, une couche barrière 812 en $Al_{33}Ga_{67}As$ de 100 nm d'épaisseur, une couche de cristal polaire (GaAs) 810 de 22 nm d'épaisseur, une couche barrière 811 en $Al_{33}Ga_{67}As$ de 90 nm d'épaisseur, une couche de protection de 10 nm en GaAs, une couche d'accroché 837 en Ti de 20 nm d'épaisseur et un réseau d'antennes optiques de couplage 834 unidimensionnel en or (Au) formé de doigts de hauteur 200 nm, de facteur de remplissage 0,65 et de période 4$\mu$m. La figure 9 comprend une première courbe 57 qui représente la réflectivité spectrale du modulateur dans une situation où les moyens de commande électriques 24 ne sont pas activés, une deuxième courbe 56 qui représente la réflectivité spectrale du modulateur dans une situation où les moyens de commande électriques 24 sont activés avec une tension de -0,3 V et une troisième courbe 58 qui représente la réflectivité spectrale du modulateur dans une situation où les moyens de commande électriques 24 sont activés avec une tension de 0,3 V. La Figure 9 met en évidence un creux de réflectivité qui caractérise une absorption du rayonnement incident pour une bande de fréquence de couplage étroite comprise dans la bande de Reststrahlen du cristal polaire. L'absorption est localisée dans le puits quantique et comme expliqué précédemment, la déposante a mis en évidence plusieurs facteurs pour expliquer cette absorption. En particulier, la fonction diélectrique du puits quantique est à la résonance proche de zéro. Dans le puits quantique, un gaz d'électrons à deux dimensions possède des niveaux d'énergie discrets dans la direction perpendiculaire à l'empilement. Des transitions intersous-bandes optiquement actives peuvent modifier le couplage du rayonnement incident au mode phonon polariton d'interface par modification de la fonction diélectrique. La contribution de ces transitions intersous-bandes à la fonction diélectrique est proportionnelle à la population d'électrons dans le puits quantique. En appliquant une tension négative sur les antennes optiques de couplage 834, il est possible de vider le puits quantique de ses électrons et d'inhiber les transitions intersous-bandes. Ceci permet de moduler en réflexion l'amplitude d'une radiation térahertz incidente de fréquence comprise dans la bande couplage en modulant la tension fournie aux moyens de commande électrique 24.

D'une manière générale, les propriétés du puits quantiques peuvent être modifiées en ajustant le diagramme de bande associé à la structure. Les calculs de bandes peuvent être faits à l'aide de codes numérique, par exemple « 1DPoisson » de G. Snider, logiciel libre de droits. En particulier, l'énergie des transitions intersous-bandes peut changer en fonction de la tension appliquée, ce qui aura aussi pour effet de plus ou moins modifier la fonction diélectrique. Cet effet connu s'appelle l'effet Stark, et a été observé par Harwitt et Harris, Applied Physics Letters, 50, 685 (1987). Dans la réalisation présentée en figure 8, donnant les résultats présentés en figure 9, l'énergie des transitions intersous-bandes est constante selon la tension appliquée, l'effet Stark étant trop faible pour être observé. Une variante pourra présenter un effet Stark prononcé. Une couche supplémentaire pourra être ajoutée à la structure de la figure 8, soit entre le puits 810 et la barrière 811 (ou 812), pour obtenir un effet Stark prononcé. Cette couche peut être par exemple en AlGaAs avec une concentration d'aluminium plus faible que celle de la barrière (<33%).

De manière générale, il y a couplage entre le plasma d'électrons et les phonons optique polaire, ce qui peut changer la fréquence à laquelle la fonction diélectrique du cristal polaire est proche de zéro, ainsi que la fréquence du mode de phonon-polariton d'interface. Ainsi, la déposante a montré que la fonction diélectrique du puits quantique pouvait également être changée uniquement par la présence d'électrons, sans que l'on ait recours à des transitions intersous-bandes.

La Figure 10 présente un graphique qui illustre la variation relative de réflectivité spectrale de l'échantillon du modulateur selon le deuxième mode de réalisation de l'invention décrit précédemment pour plusieurs angles d'incidence. La figure 10 comprend une première courbe 76 qui représente la variation relative de réflectivité spectrale de l'échantillon pour un angle d'incidence de la radiation incidente de 15°, une deuxième courbe 77 qui représente la variation relative de réflectivité spectrale de l'échantillon pour un angle d'incidence de la radiation incidente de 30° et une troisième courbe 78 qui représente la variation relative de réflectivité spectrale de l'échantillon pour un angle d'incidence de la radiation incidente de 50°. La variation relative de réflectivité est défini ici par :

$$\frac{\Delta R}{R} = \frac{R_+ - R_-}{R_-} \qquad (3)$$

où $R_-$ est la réflectivité du modulateur 1 lorsque le puits est déplété et R+ est la réflectivité du modulateur 1 lorsque des porteurs sont présents. $R_-$ est pris pour une tension de -0,3V La figure 10 met en évidence une large acceptance angulaire qui coïncide avec les calculs théoriques de l'existence d'un couplage entre le champ propagatif et le mode phonon polariton d'interface.

Notamment, le modulateur tel que décrit dans la présente demande peut s'appliquer à un système de transmission de données comprenant une source d'émission THz, le modulateur tel que décrit par exemple selon le premier ou le second mode de réalisation et un détecteur de radiation THz, le modulateur étant commandé en fonction d'un signal contenant lesdites données.

Bien que décrite à travers un certain nombre d'exemples de réalisation détaillés, le modulateur térahertz selon l'invention comprend différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent.

**Revendications**

1.  Modulateur térahertz (1) destiné à être utilisé dans une bande de fréquence d'utilisation (Δν) donnée, **caractérisé en ce qu'**il comprend:

    - un cristal semi-conducteur polaire (10) présentant une bande de Reststrahlen recouvrant ladite bande de fréquence d'utilisation et présentant au moins une interface avec un milieu diélectrique;
    - des moyens de couplage (30) permettant le couplage résonant d'un phonon polariton d'interface (IPhP) supporté par ladite interface et d'une radiation incidente (2) de fréquence comprise dans ladite bande de fréquence d'utilisation; et
    - des moyens de commande (20) aptes à modifier l'intensité du couplage entre ledit phonon polariton d'interface et ladite radiation incidente (2) par modification de la fonction diélectrique du cristal polaire (10) dans la bande de Reststrahlen du cristal polaire (10).

2.  Modulateur selon la revendication 1, dans lequel ledit cristal polaire présente au moins deux interfaces avec un milieu diélectrique, lesdites interfaces étant suffisamment rapprochées pour permettre le couplage de phonons polaritons d'interface se propageant sur chacune des interfaces (13, 14).

3.  Modulateur selon la revendication 2, dans lequel la distance entre les deux interfaces est inférieure à une centaine de nanomètres.

4.  Modulateur selon l'une quelconque des revendications précédentes, dans lequel le cristal polaire (10) est dopé.

5.  Modulateur selon l'une quelconque des revendications précédentes, dans lequel les moyens de couplage (330, 732) sont formés intégralement dans le cristal polaire.

6.  Modulateur selon la revendication 5, dans lequel le cristal polaire est structuré pour former une ou plusieurs lames de cristal (330) formant chacune une antenne optique destinée au couplage avec la radiation incidente, les grandes faces de chacune desdites lames formant deux interfaces (333, 334) avec un milieu diélectrique.

7.  Modulateur selon la revendication 6, dans lequel le cristal polaire est structuré pour former un ensemble de plusieurs lames, agencées selon une direction principale.

8.  Modulateur selon la revendication 6, dans lequel le cristal polaire est structuré pour former un ensemble de plusieurs lames, agencées selon deux directions sensiblement perpendiculaires.

9.  Modulateur selon l'une quelconque des revendications 6 à 8, dans lequel le cristal polaire est structuré pour former un ensemble de plusieurs lames et toutes les lames sont identiques.

10. Modulateur selon l'une quelconque des revendications 6 à 8, dans lequel le cristal polaire est structuré pour former un ensemble de plusieurs lames et une partie au moins des lames présentent une forme différente de celle des autres, permettant d'élargir la bande de fréquence d'utilisation du modulateur.

11. Modulateur selon l'une quelconque des revendications 6 à 10, dans lequel la ou lesdites lames sont agencées perpendiculairement à un substrat (310), ledit substrat étant destiné à être agencé dans un plan perpendiculaire au plan d'incidence de la radiation incidente (2).

12. Modulateur selon l'une quelconque des revendications 6 à 10, dans lequel la ou lesdites lames (732) sont agencées dans un plan et forment une membrane suspendue (730), le plan de la membrane étant destiné à être agencé dans un plan perpendiculaire au plan d'incidence de la radiation incidente (2).

13. Modulateur selon l'une quelconque des revendications 5 à 12, dans lequel les moyens de commande (20) comprenant une source lumineuse (22) destinée à éclairer ladite interface et de longueur d'onde donnée de sorte que l'énergie des photons produits par ladite source lumineuse soit supérieure à l'énergie de gap dudit cristal polaire (10).

**14.** Modulateur selon l'une quelconque des revendications 1 à 4, dans lequel le cristal polaire forme au moins une couche mince (810) entourée d'au moins une première et une deuxième couches barrières (811, 812) en matériau semi-conducteur diélectrique à fort énergie de gap de façon à former avec la couche en cristal polaire au moins un ou plusieurs puits quantique.

**15.** Modulateur selon la revendication 14, dans lequel les moyens de couplage (30) comprennent un ensemble de nanoantennes (834) et un miroir (836) de manière à former une cavité de résonance optique à l'intérieur de laquelle se trouve ledit ou lesdits puits quantique(s).

**16.** Modulateur selon la revendication 15, dans lequel les moyens de couplage (30) comprennent en outre un espaceur (835) pour adapter la largeur de ladite cavité de résonance optique.

**17.** Modulateur selon l'une des revendications 14 à 16, dans lequel les moyens de commande (20) sont des moyens de commande électriques (24) aptes à contrôler la densité électronique dans le(s) puits quantique(s).

**18.** Méthode de modulation d'une radiation incidente (2) de fréquence térahertz comprise dans une bande de fréquence d'utilisation donnée, incluse dans la bande de Reststrahlen d'un cristal polaire semi-conducteur (10) comprenant les étapes de :

- couplage résonant de la radiation de fréquence térahertz incidente (2) et d'un phonon polariton d'interface à une interface du cristal polaire (10) et d'un milieu diélectrique (11);
- variation de l'intensité du couplage par variation de la fonction diélectrique du cristal polaire (10) dans la bande de Reststrahlen du cristal polaire (10).

**19.** Méthode de modulation selon la revendication 18, dans laquelle la variation de la fonction diélectrique du cristal polaire (10) est obtenue en éclairant le cristal polaire (10) avec une source lumineuse (22) de longueur d'onde donnée de sorte que l'énergie des photons produits par ladite source lumineuse soit supérieure à l'énergie de gap dudit cristal polaire (10), le cristal polaire étant structuré pour former au moins une antenne permettant le couplage avec la radiation incidente.

**20.** Méthode de modulation selon la revendication 18, dans laquelle le cristal polaire (10) formant au moins une couche mince entre au moins une première et une deuxième couches barrières en matériau semi-conducteur diélectrique à fort énergie de gap de façon à former un ou plusieurs puits quantique(s), la variation de la fonction diélectrique du cristal polaire (10) est obtenue en appliquant une tension au cristal polaire (10) pour contrôler la densité électronique dans le(s) puits quantique(s).

## Patentansprüche

**1.** Terahertz-Modulator (1), der zur Verwendung in einem gegebenen Verwendungsfrequenzband ($\Delta\nu$) geeignet ist, **dadurch gekennzeichnet, dass** er Folgendes umfasst:

- einen polaren Halbleiterkristall (10), der ein Band von Reststrahlen aufweist, das das Verwendungsfrequenzband einbezieht und mindestens eine Schnittstelle mit einem dielektrischen Medium aufweist;
- Kopplungsmittel (30), die die mitschwingende Kopplung eines Schnittstellenphononenpolaritons (IPhP), das von der Schnittstelle unterstützt wird, und einer einfallenden Strahlung (2) einer im Verwendungsfrequenzband enthaltenen Strahlung ermöglichen; und
- Steuerungsmittel (20), die geeignet sind, die Intensität der Kopplung zwischen dem Schnittstellenphononenpolariton und der einfallenden Strahlung (2) durch Modifikation der dielektrischen Funktion des polaren Kristalls (10) im Reststrahlenband des polaren Kristalls (10) zu modifizieren.

**2.** Modulator nach Anspruch 1, wobei der polare Kristall mindestens zwei Schnittstellen mit einem dielektrischen Medium aufweist, wobei die Schnittstellen nahe genug beieinander liegen, um die Kopplung der Schnittstellenphononenpolaritons zu ermöglichen, die sich auf jeder Schnittstelle (13, 14) ausbreiten.

**3.** Modulator nach Anspruch 2, wobei der Abstand zwischen den beiden Schnittstellen geringer ist als hundert Nanometer.

4. Modulator nach einem der vorstehenden Ansprüche, wobei das polare Kristall (10) dotiert ist.

5. Modulator nach einem der vorstehenden Ansprüche, wobei die Kopplungsmittel (330, 732) integral in dem polaren Kristall ausgebildet sind.

6. Modulator nach Anspruch 5, wobei das polare Kristall dazu strukturiert ist, eine oder mehrere Kristalllamellen (330) auszubilden, die jede eine optische Antenne bilden, die zur Kopplung mit der einfallenden Strahlung geeignet ist, wobei die großen Oberflächen der Lamellen zwei Schnittstellen (333, 334) mit einem dielektrischen Medium bilden.

7. Modulator nach Anspruch 6, wobei das polare Kristall dazu strukturiert ist, eine Gesamtheit von mehreren Lamellen auszubilden, die in einer Hauptrichtung angeordnet sind.

8. Modulator nach Anspruch 6, wobei das polare Kristall dazu strukturiert ist, eine Gesamtheit von mehreren Lamellen auszubilden, die in zwei im Wesentlichen senkrechten Richtungen angeordnet sind.

9. Modulator nach einem der Ansprüche 6 bis 8, wobei der polare Kristall dazu strukturiert ist, eine Gesamtheit von mehreren Lamellen auszubilden, und wobei alle Lamellen identisch sind.

10. Modulator nach einem der Ansprüche 6 bis 8, wobei der polare Kristall dazu strukturiert ist, eine Gesamtheit von mehreren Lamellen auszubilden, und wobei ein Teil der Lamellen eine von den anderen verschiedene Form aufweist, was die Erweiterung des Verwendungsfrequenzbands des Modulators ermöglicht.

11. Modulator nach einem der Ansprüche 6 bis 10, wobei die Lamelle oder Lamellen senkrecht in einem Substrat (310) angeordnet sind, wobei das Substrat zur Anordnung in einer Ebene senkrecht zur Einfallebene der einfallenden Strahlung (2) geeignet ist.

12. Modulator nach einem der Ansprüche 6 bis 10, wobei die Lamelle oder Lamellen (732) in einer Ebene angeordnet sind und eine aufgehängte Membran (730) bilden, wobei die Membranebene zur Anordnung in einer Ebene senkrecht zur Einfallebene der einfallenden Strahlung (2) geeignet ist.

13. Modulator nach einem der Ansprüche 5 bis 12, wobei die Steuerungsmittel (20) eine Lichtquelle (22) umfassen, die dazu geeignet ist, die Schnittstelle zu beleuchten, und die eine gegebene Wellenlänge derart aufweist, dass die Energie der von der Lichtquelle erzeugten Photonen größer ist als die Energie des Gaps des polaren Kristalls (10).

14. Modulator nach einem der Ansprüche 1 bis 4, wobei das polare Kristall mindestens eine Dünnschicht (810) ausbildet, die von mindestens einer ersten und einer zweiten Sperrschicht (811, 812) aus dielektrischem Halbleitermaterial mit hoher Energie des Gaps umgeben ist, um mit der polaren Kristallschicht mindestens ein oder mehrere Quantentöpfe auszubilden.

15. Modulator nach Anspruch 14, wobei die Kopplungsmittel (30) eine Gesamtheit aus Nanoantennen (834) und einen Spiegel (836) umfassen, um einen optischen Resonanzhohlraum zu bilden, in dessen Inneren sich der oder die Quantentöpfe befinden.

16. Modulator nach Anspruch 15, wobei die Kopplungsmittel (30) unter anderem einen Abstandshalter (835) umfassen, um die Größe des optischen Resonanzhohlraums anzupassen.

17. Modulator nach einem der Ansprüche 14 bis 16, wobei die Steuermittel (20) elektrische Steuermittel (24) sind, die die elektronische Dichte in dem oder den Quantentöpfen steuern können.

18. Verfahren zur Modulation einer einfallenden Strahlung (2) einer Terahertzfrequenz, die in einem gegebenen Verwendungsfrequenzband liegt, das in dem Reststrahlenband eines polaren Halbleiterkristalls (10) eingeschlossen ist, das die folgenden Schritte umfasst:

   - mitschwingende Kopplung der einfallenden Strahlung der Terahertzfrequenz (2) und eines Schnittstellenphononenpolaritons mit einer Schnittstelle des polaren Kristalls (10) und einem dielektrischen Medium (11);
   - Variation der Kopplungsintensität durch Variation der dielektrischen Funktion des polaren Kristalls (10) in dem Reststrahlenband des polaren Kristalls (10).

**19.** Modulationsverfahren nach Anspruch 18, wobei man die Variation der dielektrischen Funktion des polaren Kristalls (10) durch Beleuchten des polaren Kristalls (10) mit einer Lichtquelle (22) einer gegeben Wellenlänge erhält, so dass die Energie der von der Lichtquelle erzeugten Photonen größer ist als die Energie des Gaps des polaren Kristalls (10), wobei das polare Kristall dazu strukturiert ist, mindestens eine Antenne auszubilden, die die Kopplung mit der einfallenden Strahlung ermöglicht.

**20.** Modulationsverfahren nach Anspruch 18, wobei der polare Kristall (10) mindestens eine Dünnschicht zwischen mindestens einer ersten und einer zweiten Sperrschicht aus dielektrischem Halbleitermaterial mit hoher Energie des Gaps bildet, um einen oder mehrere Quantentöpfe zu bilden, wobei man die Variation der dielektrischen Funktion des polaren Kristalls (10) durch Ausüben einer Spannung auf den polaren Kristall (10) zum Steuern der elektronischen Dichten in dem oder den Quantentöpfen erhält.

**Claims**

**1.** Terahertz modulator (1) intended to be used in a given frequency band of use ($\Delta\nu$), **characterized in that** it comprises :

 - a semi-conductor polar crystal (10) having a Reststrahlen band, covering said frequency band of use and having at least one interface with a dielectric medium;
 - coupling means (30) allowing the resonant coupling of an interface polariton phonon (IPPh) supported by said interface and of an incident radiation (2) of frequency in said frequency band of use; and
 - control means (20) apt to modify the intensity of the coupling between said interface polariton phonon and said incident radiation (2) by modification of the dielectric function of the polar crystal (10) in the Reststrahlen band of the polar crystal (10).

**2.** Modulator as claimed in claim 1, in which said polar crystal has at least two interfaces with a dielectric medium, said interfaces being sufficiently close to allow the coupling of interface polariton phonons propagating along each of said interfaces (13, 14).

**3.** Modulator as claimed in claim 2, in which the distance between the two interfaces is less than a hundred nanometers.

**4.** Modulator as claimed in any one of the previous claims, in which the polar crystal (10) is doped.

**5.** Modulator as claimed in any one of the previous claims, in which the coupling means (330, 732) are integrally formed in the polar crystal.

**6.** Modulator as claimed in claim 5, in which the polar crystal is structured to form one or a plurality of crystal blades (330) each forming an optical antenna intended for coupling with the incident radiation, the large faces of each of said blades forming two interfaces (333, 334) with a dielectric medium.

**7.** Modulator as claimed in claim 6, in which the polar crystal is structured to form a group of plurality blades, laid out along a principal direction.

**8.** Modulator as claimed in claim 6, in which the polar crystal is structured to form a group of plurality blades, laid out along two substantially perpendicular directions.

**9.** Modulator as claimed in any of claims 6 to 8, in which the polar crystal is structured to form a group of plurality blades and each blade being identical.

**10.** Modulator as claimed in any of claims 6 to 8, in which the polar crystal is structured to form a group of plurality blades and at least a part of the blades have a different shape from that of the others, allowing the frequency band of use of the modulator to be widened .

**11.** Modulator as claimed in any of claims 6 to 10, in which the said blade(s) are laid out perpendicular to a substrate (310), said substrate being intended to be laid out in a plane perpendicular to the incident plane of the incident radiation (2).

**12.** Modulator as claimed in any of claims 6 to 10, in which the said blade(s) (732) are laid out in a plane and form a suspended membrane (730), the plane of the membrane being intended to be laid out in a plane perpendicular to the incident plane of the incident radiation (2).

**13.** Modulator as claimed in any of claims 5 to 12, in which the means of control (20) comprise a light source (22) intended to illuminate said interface and with a given wavelength such that the energy of the photons produced by said light source is greater than the energy gap of said polar crystal (10).

**14.** Modulator as claimed in any of the claims 1 to 4, in which the polar crystal forms at least one thin layer (810) surrounded by at least one first and one second barrier layers (811, 812) of semi-conductor dielectric material with a high energy gap so as to form with the polar crystal layer, at least one or a plurality of quantum wells.

**15.** Modulator as claimed in claim 14, in which the coupling means (30) comprise a group of nanoantennas (834) and a mirror (836) so as to form an optical resonance cavity inside of which said quantum well(s) are located.

**16.** Modulator as claimed in claim 15, in which the coupling means (30) in addition comprise a spacer (835) to adapt the width of said optical resonance cavity.

**17.** Modulator as claimed in any of the claims 14 to 16, in which the means of control (20) are electrical means of control (24) apt to control the electron density in the quantum well(s).

**18.** A method of modulating an incident radiation (2) of terahertz frequency in a given frequency band of use, included in the Reststrahlen band of a semi-conductor polar crystal (10) comprising the steps of:

- resonant coupling of the incident terahertz frequency radiation (2) and of an interface polariton phonon at an interface of the polar crystal (10) and of a dielectric medium (11);
- variation of the intensity of the coupling by variation of the dielectric function of the polar crystal (10) in the Reststrahlen band of the polar crystal (10).

**19.** Method of modulation as claimed in claim 18, in which the variation of the dielectric function of the polar crystal (10) is obtained by illuminating the polar crystal (10) with a light source (22) of a given wavelength such that the energy of the photons produced by said light source is greater than the energy gap of said polar crystal (10), the polar crystal being structured to form at least one antenna allowing coupling with the incident radiation.

**20.** Method of modulation as claimed in claim 18, in which the polar crystal (10) forming at least a thin layer between at least a first and a second barrier layer of semi-conductor dielectric material with a high energy gap so as to form one or a plurality of quantum wells, the variation of the dielectric function of the polar crystal (10) is obtained by applying a voltage to the polar crystal (10) to control the electron density in the quantum well(s).

FIG.1

FIG.3

FIG.2A

FIG.2B

EP 2 676 166 B1

FIG.4A

FIG.4B

19

FIG.5

FIG.6

FIG.7A

FIG.7B

FIG.8

FIG.9

FIG.10

# EP 2 676 166 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- **JANKE et al.** All-optical switching of the transmission electromagnetic radiation through subwavelength apertures. *Optics Lettres,* 2005, vol. 30 (18), 2357-2359
- **X.WU et al.** Thermally Tunning Surface Plasmon Polaritons in Corrugates Semiconductor Films. *Japanese Journal of Applied Physics,* 2009, vol. 48, 042302
- **M. BORN ; K. HUANG.** dynamical theory of crystal lattices. Oxford University Press, 1954
- **L.NOVOTNY et al.** Antennas for light. *nature photonics,* Février 2011, vol. 5
- **L. LI.** « Rigourous Coupled Wave Analysis » (RCWA). *Journal of Optical Society of America A,* 1997, vol. 14 (10), 2758
- **P . BOUCHON.** «Rigourous Maxwell with Constitutive B-spline approximation» (RMCB). *Journal of Optical Society of America A,* 2010, vol. 27 (4), 696
- **HARWITT ; HARRIS.** *Applied Physics Letters,* 1987, vol. 50, 685